# FASCICULE DE BREVET EUROPEEN

(11) **EP 1 134 859 B1**
(45) Date de publication et mention de la délivrance du brevet: **28.11.2007**
(21) Numéro de dépôt: 01400465.9
(22) Date de dépôt: 22.02.2001
(51) Int. Cl.: H01S 5/50, H04B 10/17

(54) **Dispositif d'amplification optique**
Optische Verstärkungsvorrichtung
Optical amplifying device

(30) Priorité: 16.03.2000 FR 0003373
(43) Date de publication de la demande: 19.09.2001
(73) Titulaire: Avanex Corporation, Fremont, CA 94538 (US)
(72) Inventeur: Zami, Thierry, 91300 Massy (FR); Chiaroni, Dominique, 92160 Antony (FR); Le Sauze, Nicolas, 92370 Chaville (FR); Pons, Alain, 91340 Ollainville (FR); Emery, Jean-Yves, 91120 Palaiseau (FR); Dorgeuille, Francois, 75014 Paris (FR)
(74) Mandataire: Feray, Valérie

(56) Documents cités:
- EP-A- 0 881 790
- MANABU YOSHINO ET AL: "IMPROVEMENT OF SATURATION OUTPUT POWER IN A SEMICONDUCTOR LASER AMPLIFIER THROUGH PUMPING LIGHT IMJECTION" IEEE PHOTONICS TECHNOLOGY LETTERS,IEEE INC. NEW YORK,US, vol. 8, no. 1, 1996, pages 58-59, XP000547533 ISSN: 1041-1135
- MA B ET AL: "REALIZATION OF ALL-OPTICAL WAVELEGTH CONVERTER BASED ON DIRECTIONALLY COUPLED SEMICONDUCTOR OPTICAL AMPLIFIERS" IEEE PHOTONICS TECHNOLOGY LETTERS,IEEE INC. NEW YORK,US, vol. 11, no. 2, février 1999 (1999-02), pages 188-190, XP000803424 ISSN: 1041-1135
- PATENT ABSTRACTS OF JAPAN vol. 015, no. 140 (P-1188), 9 avril 1991 (1991-04-09) & JP 03 017633 A (HITACHI LTD), 25 janvier 1991 (1991-01-25)

## Description

L'invention se situe dans le domaine des systèmes de transmission optique mono-longueur d'onde ou à multiplexage en longueur d'onde (en anglais : "Wavelength Division Multiplexing" ou "WDM"). Elle concerne plus particulièrement l'amplification des signaux optiques véhiculés dans ces systèmes.

L'amplification pour la transmission de signaux optiques modulés en amplitude est généralement réalisée au moyen d'amplificateurs à fibre, tels que les amplificateurs à fibre dopée à l'erbium, car ils ne présentent pas de non-linéarité de gain en fonction de la puissance du signal d'entrée pour les fréquences de modulation (de l'ordre de 100 MHz à 10 GHz) des signaux utilisés. En effet, bien que ces amplificateurs présentent un phénomène de saturation de gain, dans le cas d'une transmission de signaux binaires à plusieurs gigabits par seconde, la durée de vie des porteurs est suffisamment longue par rapport au temps bit pour que le gain reste insensible aux fluctuations de puissance optique correspondant à la modulation binaire.

Par contre, dans les amplificateurs optiques semi-conducteurs, la durée de vie des porteurs est suffisamment courte pour qu'en régime de saturation le gain varie au rythme de la modulation. Il en résulte une dégradation du taux d'extinction correspondant à la compression de gain. Si par contre on veut conserver une réponse linéaire, on doit limiter la puissance optique d'entrée, ce qui est défavorable au rapport signal à bruit.

Ce problème se pose en particulier dans le cas de l'amplification d'un signal mono-longueur d'onde. Dans le cas d'un signal WDM, la puissance optique instantanée injectée dans l'amplificateur est la somme de celles des canaux qui constituent le signal et des impulsions de plusieurs canaux se superposent en nombre variable à chaque instant mais souvent avec des phases aléatoires. Ceci peut entraîner de fortes variations temporaires, à fréquences élevées, de la puissance du signal, mais ces fréquences sont généralement filtrées par l'amplificateur. Si par contre les impulsions sont en phase, le problème devient très critique. En effet, après amplification et démultiplexage spectral, les impulsions de chaque canal présentent des taux d'extinction dégradés et variables d'une impulsion à l'autre, ce qui nuit à la qualité de la détection au niveau du récepteur.

Le problème de la saturation de gain des amplificateurs optiques semi-conducteurs se pose aussi dans le cas où ils sont utilisés comme portes optiques dans les systèmes de commutations pour réseaux optiques. En effet, pour supporter de forts débits, il faut assurer un bon rapport signal à bruit. Cela impose des puissances élevées aux signaux injectés dans les portes, mais le taux d'extinction est alors dégradé.

Ainsi, malgré les avantages de coût et de compacité des amplificateurs semi-conducteurs, leur domaine d'utilisation s'en trouve limité.

Pour résoudre ce problème, une première approche a consisté à chercher à augmenter leur puissance de saturation en optimisant leur dimensionnement et la composition des couches semi-conductrices qui les constituent ou bien à adopter des structures actives complexes telles que les puits quantiques multiples.

Une autre approche consiste à utiliser un amplificateur à gain stabilisé tel que décrit par exemple dans la demande de brevet européen EP-A-639876, publiée le 22 février 1995. Cette solution permet bien d'étendre la plage de fonctionnement linéaire de l'amplificateur mais présente l'inconvénient d'une dynamique en puissance limitée, ce qui est particulièrement contraignant pour les signaux WDM. En outre, le gain des amplificateurs à gain stabilisé est fixé par fabrication, ce qui réduit sa flexibilité à l'égard des diverses applications et contextes d'utilisation

L'invention a pour but d'échapper aux limitations des méthodes évoquées ci-dessus. Pour cela, elle propose une solution avec des moyens externes permettant d'utiliser des amplificateurs semi-conducteurs de type classique et fonctionnant en régime de saturation de gain tout en assurant un gain constant au signaux modulés à amplifier.

Plus précisément, l'invention a pour objet un dispositif pour amplifier au moyen d'un amplificateur optique semi-conducteur un signal optique modulé en amplitude, appelé signal à amplifier, et porté par au moins une longueur d'onde de signal, caractérisé en ce qu'il comporte :
- des moyens de compensation pour produire une onde optique de compensation,
- des moyens de couplage pour injecter dans ledit amplificateur ledit signal optique à amplifier et ladite onde optique de compensation,
et en ce que lesdits moyens de compensation comprennent des moyens de modulation directement commandés en fonction de la modulation du signal à amplifier, pour produire ladite onde optique de compensation par modulation d'amplitude d'au moins une onde porteuse optique auxiliaire, de sorte que la combinaison dudit signal optique à amplifier et de ladite onde optique de compensation présente une modulation d'amplitude supprimée ou au moins atténuée.

Pour supprimer toute modulation de la puissance optique totale injectée dans l'amplificateur, il faudrait que l'onde de compensation engendrée par les moyens de modulation soit modulée en inverse par rapport à la modulation du signal optique à amplifier et que les amplitudes de modulation du signal et de l'onde de compensation soient à tout instant égales en valeur absolue. Toutefois, si ces conditions ne sont pas entièrement satisfaites, on obtiendra tout de même une sensible amélioration de la linéarité de l'amplification.

Selon une caractéristique supplémentaire de l'invention, l'onde porteuse optique auxiliaire a une longueur d'onde de compensation distincte de ladite ou desdites longueur(s) d'onde de signal. Cette disposition est nécessaire dans le cas où l'onde de compensation et le signal optique à amplifier sont codirectionnels, c'est-à-dire ont le même sens de propagation dans l'amplificateur, car il faut pouvoir ultérieurement éliminer par filtrage l'onde de compensation. Dans le cas contraire, cette disposition est en pratique tout de même souhaitable pour éviter des bruits de battement entre le signal et l'onde de compensation.

Dans de nombreuses applications, on a besoin d'amplifier un signal reçu sous forme optique. Ce signal reçu ou un prélèvement de ce signal constitue un signal d'entrée du dispositif et les moyens de modulation doivent alors retranscrire sa modulation en inverse (en opposition de phase) sur la longueur d'onde compensation. Par ailleurs, l'onde de compensation et le signal à amplifier, c'est-à-dire le signal correspondant à ce signal d'entrée et injecté dans l'amplificateur, doivent présenter des modulations bien synchrones.

Aussi, le dispositif selon l'invention est en outre caractérisé en ce que lesdits moyens de compensation comportent un dispositif à retard fournissant ledit signal à amplifier à partir d'un signal optique d'entrée et en ce que lesdits moyens de modulation sont aptes à moduler l'amplitude de ladite onde porteuse optique auxiliaire en inverse par rapport à la modulation dudit signal d'entrée.

Pour atténuer fortement la modulation de la puissance optique totale injectée dans amplificateur, il convient que les moyens de modulation présentent une bonne linéarité vis à vis du complément du signal d'entrée. Ce but peut être atteint facilement au moyen de conversions optoélectronique puis électrooptique.

Ainsi, selon une première possibilité de réalisation, les moyens de modulation comportent un photodétecteur recevant une partie du signal optique d'entrée et commandant un modulateur électrooptique. L'onde optique de compensation résulte alors de la modulation de l'onde auxiliaire au moyen du modulateur électrooptique.

Quel que soit le modulateur électrooptique choisi, on pourra toujours obtenir une réponse suffisamment linéaire en ajustant la commande appliquée et/ou en limitant l'excursion de cette commande. Par ailleurs, en ajustant le niveau de puissance de l'onde auxiliaire, on peut égaliser les amplitudes de modulation du signal à amplifier et de l'onde de compensation.

Le modulateur électrooptique peut être un modulateur à structure interférométrique ou un modulateur à électroabsorption. On pourra préférer cette dernière variante pour disposer d'une réponse linéaire sur une plage d'amplitude de modulation plus étendue. En variante, le modulateur électrooptique et la source laser sont constitués d'un laser à modulateur intégré.

Les moyens de modulation peuvent aussi être réalisés de façon toute optique. Pour les très hauts débits, cette solution présente l'avantage d'éviter le développement de circuits électroniques devant travailler à haute fréquence.

Ainsi, selon une seconde possibilité de réalisation, les moyens de modulation comportent un second amplificateur optique semi-conducteur recevant ladite onde porteuse optique auxiliaire et une partie dudit signal optique d'entrée, ladite onde optique de compensation résultant de l'amplification de ladite onde auxiliaire au moyen dudit second amplificateur, dont le gain est modulé par ladite partie du signal optique d'entrée.

En variante, les moyens de modulation comportent une structure interférométrique munie de deux branches ayant chacune des premières et secondes extrémités, lesdites premières extrémités recevant respectivement une partie de ladite onde auxiliaire, une desdites branches comprenant un matériau dont l'indice varie en fonction de la puissance optique reçue et recevant une partie dudit signal optique d'entrée, lesdites secondes extrémités étant couplées pour fournir ladite onde optique de compensation.

L'invention peut aussi s'appliquer au cas où le signal optique à amplifier est produit à partir d'un signal d'entrée disponible sous forme électrique. Les moyens de modulation peuvent alors utiliser directement ce signal électrique d'entrée.

Dans ce cas, le dispositif est caractérisé en ce que lesdits moyens de modulation sont constitués d'un modulateur électrooptique recevant ladite onde auxiliaire et commandé par un signal électrique complémentaire dudit signal électrique d'entrée.

Avantageusement, l'amplificateur optique semi-conducteur possède une fréquence de coupure inférieure à celle desdits moyens de modulation.

D'autres aspects et avantages de l'invention apparaîtront dans la suite de la description en référence aux figures.
- La figure 1 représente un amplificateur optique semi-conducteur utilisé dans la présente invention.
- La figure 2 représente une courbe de gain de l'amplificateur de la figure 1.
- La figure 3 représente des chronogrammes pour expliquer le fonctionnement de l'amplificateur de la figure 1.
- La figure 4 représente schématiquement un dispositif selon l'invention.
- La figure 5 représente des chronogrammes pour expliquer le fonctionnement du dispositif de la figure 4.
- La figure 6 représente un premier mode de réalisation du dispositif selon l'invention.
- La figure 7 est une courbe représentant les variations de la transmission d'un modulateur électrooptique à structure interférométrique.
- La figure 8 représente un second mode de réalisation du dispositif selon l'invention.
- Les figures 9 à 11 représentent des variantes de réalisation des dispositifs selon respectivement les figures 6, 8 et 4.
- La figure 12 représente un troisième mode de réalisation du dispositif selon l'invention.

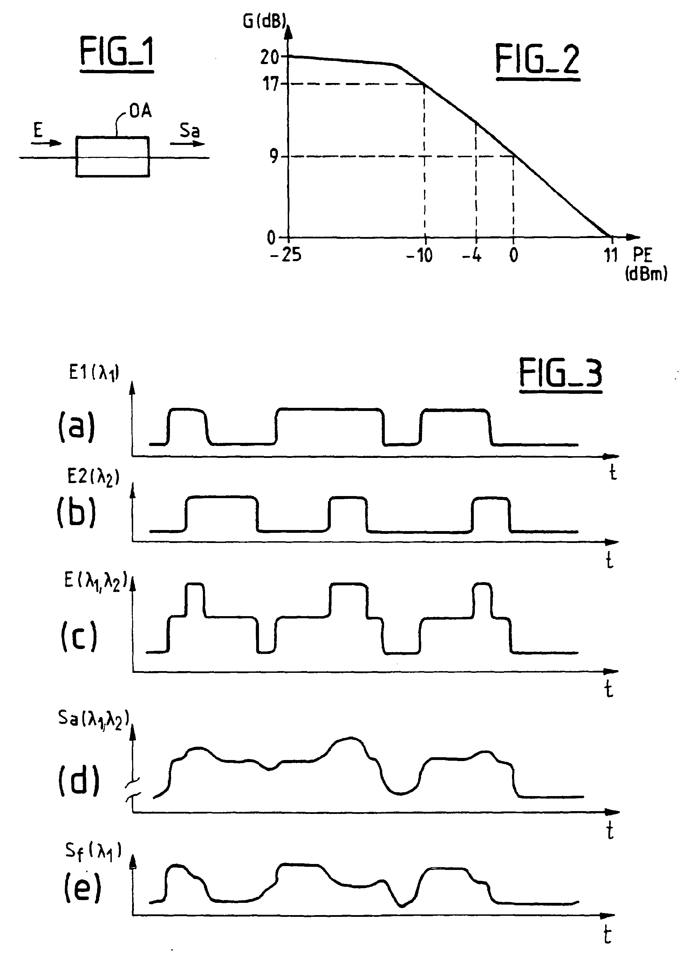

L'amplificateur optique semi-conducteur OA représenté schématiquement sur la figure 1 est de type conventionnel. Il reçoit normalement en entrée un signal à amplifier E et fournit en sortie le signal amplifié Sa.

Le gain G de l'amplificateur est défini comme le rapport entre la puissance optique du signal de sortie Sa et la puissance optique du signal d'entrée E.

Le gain G varie en fonction de la puissance optique PE du signal d'entrée E selon une courbe de gain telle que celle représentée à titre d'exemple sur la figure 2. Sur cette figure, le gain est exprimé en décibels et la puissance optique en dBm.

Pour les faibles puissances optiques, le gain est constant et l'amplificateur fonctionne en régime linéaire. Par contre, à partir d'un certain niveau de puissance d'entrée, la valeur du gain diminue au fur et à mesure que la puissance augmente.

On définit la puissance de saturation d'entrée de l'amplificateur comme la puissance d'entrée pour laquelle le gain a une valeur égale à la moitié du gain maximum de l'amplificateur, c'est-à-dire pour un gain exprimé en dB inférieur de 3dB par rapport au gain maximum. Dans l'exemple représenté, le gain maximum est de 20 dB et la puissance de saturation est de -10dBm. Au delà de la puissance de saturation, le gain en dB diminue de façon pratiquement linéaire en fonction de la puissance optique d'entrée en dBm.

Les chronogrammes de la figure 3 vont permettre d'expliquer le fonctionnement de l'amplificateur lorsque le signal à amplifier est un signal multiplex WDM. Pour simplifier, on suppose que le multiplex est constitué seulement de deux canaux correspondant aux signaux E1 et E2 portés respectivement par les longueurs d'onde de signal λ1 et λ2.

Dans l'exemple représenté par les chronogrammes (a) et (b), les informations véhiculées par les signaux E1 et E2 sont inscrites sous la forme de modulations d'amplitude (ou puissance optique) d'ondes porteuses ayant les longueurs d'onde λ1 et λ2. Il s'agit ici de signaux binaires ayant un format de codage NRZ.

La puissance optique instantanée du signal multiplex E est la somme des puissances instantanées des deux signaux E1, E2 et présente alors une modulation d'amplitude représentée par le chronogramme (c).

L'amplificateur OA délivre en sortie le signal amplifié Sa. Compte tenu de la saturation de gain exposée précédemment, les niveaux hauts de puissance sont moins amplifiés que les niveaux bas et on obtient une modulation déformée telle que représentée par le chronogramme (d). Pour extraire ensuite le canal E1 par exemple, on effectue un filtrage calé sur la longueur d'onde λ1. On obtient alors un signal filtré Sf qui présente une modulation très déformée, comme le montre le chronogramme (e).

Si de plus les canaux sont synchrones et sont en nombre élevé, les déformations peuvent être très importantes et conduire à de nombreuses erreurs de lecture au niveau du récepteur, même s'il s'agit de signaux numériques.

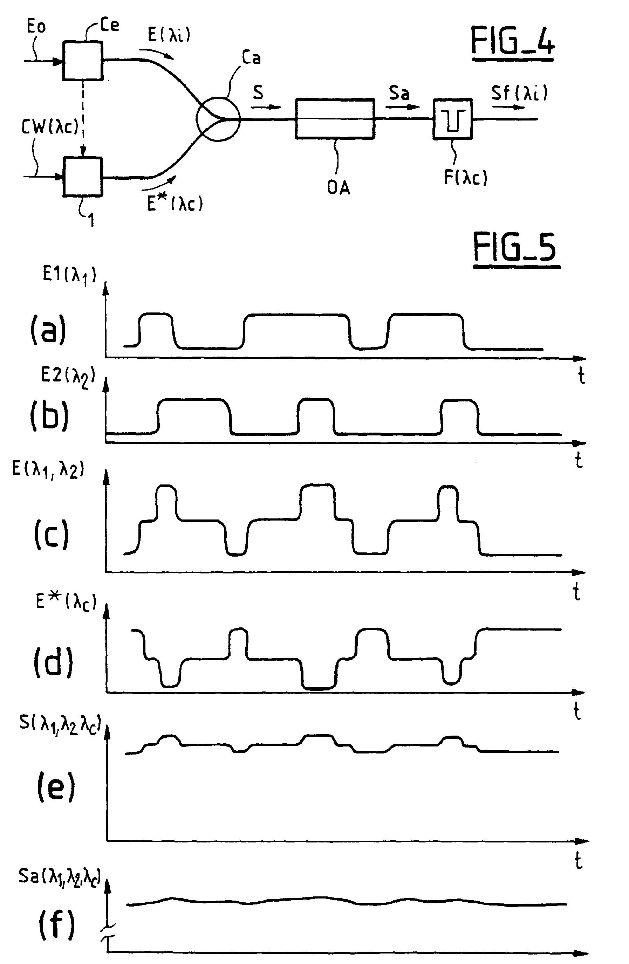

Conformément à l'invention, le dispositif représenté dans son principe par la figure 4 permet de résoudre ce problème.

Le dispositif comprend l'amplificateur optique semi-conducteur OA et des moyens de couplage Ca permettant de lui injecter la combinaison S du signal optique à amplifier E et d'une onde optique de compensation E*.

Le signal à amplifier E est généralement obtenu par une interface d'entrée Ce recevant un signal d'entrée E0 qui peut être un signal optique mono-longueur d'onde ou, comme précédemment, un signal WDM composé de plusieurs signaux portés des longueur(s) d'onde de signal λi. Le signal d'entrée E0 peut être aussi un signal électrique et dans ce cas, l'interface Ce aura une fonction de convertisseur électrooptique.

L'onde de compensation E* est produite par des moyens de modulation 1 sensibles à la modulation du signal d'entrée E0 et donc à celle du signal à amplifier E. Ils sont conçus pour moduler au moins une onde porteuse optique auxiliaire CW, ayant une longueur d'onde dite de compensation λc, de sorte que la combinaison S du signal E et de l'onde E* présente une modulation d'amplitude supprimée ou au moins atténuée. L'amplificateur OA délivre en sortie le signal de combinaison amplifié Sa.

Selon le montage représenté, le signal E et l'onde de compensation E* sont codirectionnels, c'est-à-dire injectés dans l'amplificateur par une même face. Dans ce cas, on prévoit en aval un filtre réjecteur F calé sur la longueur d'onde de compensation λc. Il faut bien entendu que la longueur d'onde de compensation λc soit distincte de la ou des longueur(s) d'onde de signal λi pour que le filtre puisse extraire l'onde de compensation E* et transmettre le signal utile amplifié Sf.

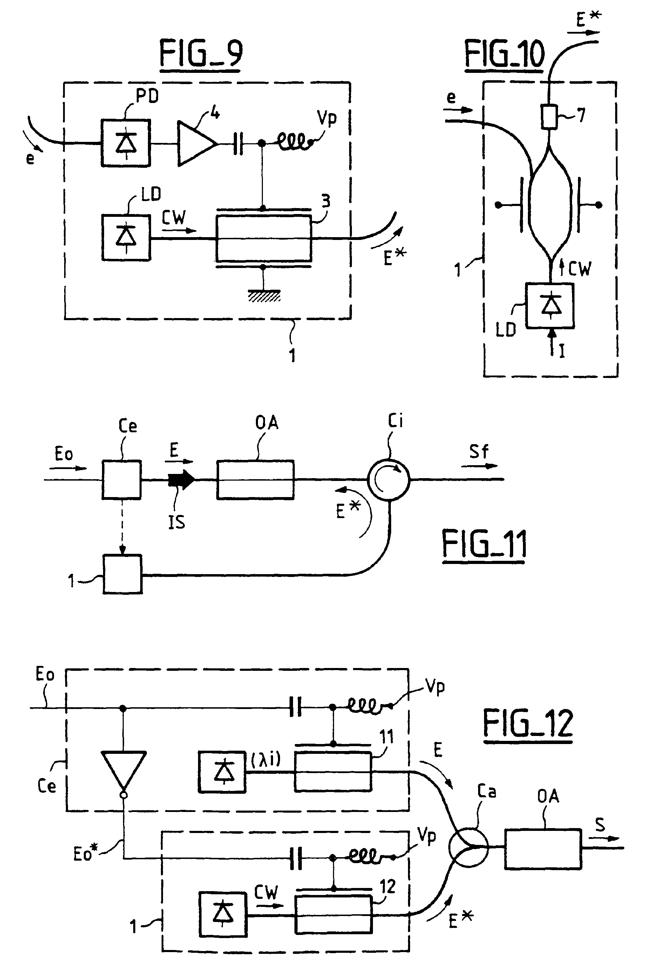

Selon une variante représentée à la figure 11, le signal E et l'onde compensation E* sont contradirectionnels, c'est-à-dire injectés dans l'amplificateur par des faces opposées. Les moyens de couplage Ca comportent d'une part un isolateur IS disposé entre l'interface d'entrée Ce et une première face de l'amplificateur OA, et d'autre part un circulateur Ci placé entre les moyens de modulation 1 et une seconde face de l'amplificateur OA. Dans ce cas, la présence en aval du filtre réjecteur F n'est plus nécessaire. Par contre, un tel filtre pourrait remplacer l'isolateur IS.

Avec ce montage contradirectionnel la longueur d'onde de compensation λc pourrait être voisine de l'une des longueurs d'onde de signal λi. Il convient toutefois d'éviter de choisir des longueurs d'onde identiques car cela générerait un bruit d'interférence entre l'onde de compensation et le signal.

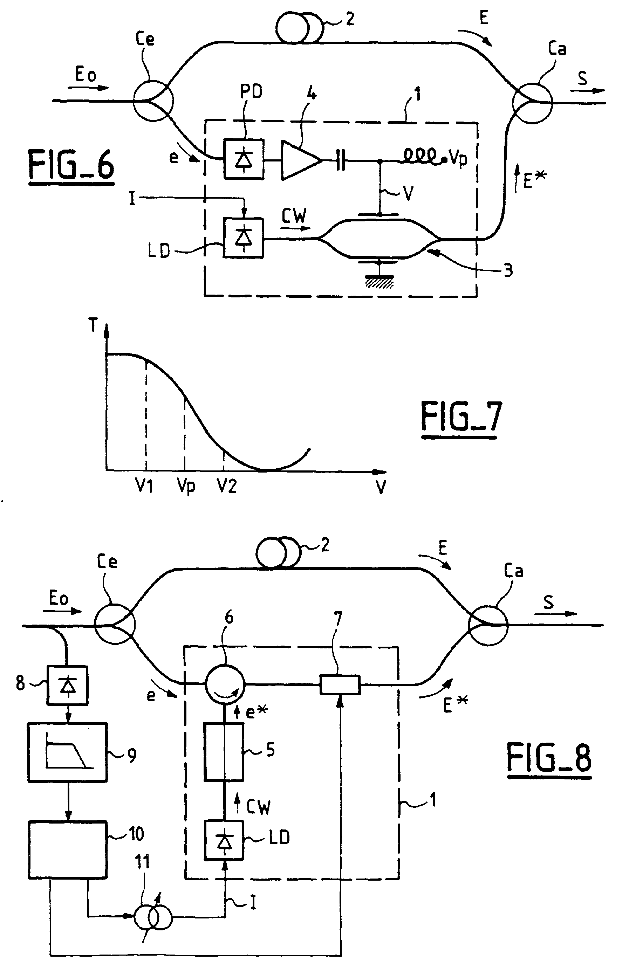

Le fonctionnement du dispositif selon l'invention est maintenant expliqué en référence aux chronogrammes de la figure 5. Comme dans l'exemple précédent, le signal à amplifier E est constitué des deux canaux E1 et E2. Les signaux E1, E2 et E sont représentés respectivement sur les chronogrammes (a), (b) et (c).

L'onde de compensation E* est représentée par le chronogramme (d). Le signal de combinaison S dont la puissance instantanée est la somme des puissances instantanées de E et E* apparaît sur le chronogramme (e). Le signal de combinaison amplifié Sa apparaît sur le chronogramme (f).

L'onde de compensation E* est modulée en inverse par rapport à la modulation du signal E. Si les amplitudes de modulation de E et E* sont à tout instant rigoureusement égales en valeur absolue, le signal de combinaison S ne présente plus aucune modulation de la puissance optique. Ce cas idéal est représenté en pointillés sur les chronogrammes (d) et (e) .

En pratique, on pourra toutefois seulement se contenter d'atténuer la modulation de S. En effet, l'amplificateur OA étant insensible aux modulations à haute fréquence, il a un rôle de filtre passe-bas. Si sa fréquence de coupure est inférieure à celle des moyens de modulation 1, toute modulation résiduelle de S sera atténuée par l'amplification. On aura donc intérêt à choisir un amplificateur OA lent, c'est-à-dire à faible facteur de confinement et/ou de faible longueur.

La figure 6 représente un premier mode de réalisation du dispositif selon l'invention dans le cas où on veut amplifier un signal d'entrée E0 disponible seulement sous forme optique.

L'interface d'entrée Ce est constituée d'un coupleur d'entrée dont l'entrée reçoit ce signal E0. Une première sortie du coupleur Ce est couplée à l'amplificateur OA (non représenté) par l'intermédiaire d'une ligne à retard 2 et du coupleur Ca. Une seconde sortie du coupleur Ce est couplée aux moyens de modulation 1. Le signal optique à amplifier E correspond ici à une partie du signal optique d'entrée E0, retardée par la ligne à retard 2. Les moyens de modulation 1 reçoivent du coupleur Ce une autre partie e du signal optique d'entrée E0 et fournissent à l'amplificateur OA, par l'intermédiaire d'un coupleur Ca, l'onde optique de compensation E*.

Selon cette réalisation, les moyens de modulation 1 comportent un modulateur électrooptique 3 à structure interférométrique de type Mach-Zehnder. Un photodétecteur PD reçoit la partie e du signal optique d'entrée E0. Le signal électrique qu'il fournit est appliqué à une électrode de commande du modulateur 3 par l'intermédiaire d'un amplificateur électronique 4 et d'un coupleur en T. Ce dernier permet de superposer la composante alternative de la tension issue du photodétecteur PD à une tension de polarisation Vp choisie.

Une source laser LD délivrant l'onde porteuse continue CW de longueur d'onde λc est couplée au modulateur Mach-Zehnder 3 qui fournit en sortie l'onde optique de compensation E*.

L'amplificateur électronique 4 et le modulateur 3 sont choisis pour que l'onde porteuse CW soit modulée en inverse par rapport à la modulation du signal E0. La ligne à retard 2 sert à synchroniser le signal à amplifier E avec l'onde de compensation E*.

Pour que l'amplitude de modulation de l'onde de compensation E* compense celle du signal E , il faut que les moyens de modulation 1 possèdent une réponse "antilinéaire" par rapport au signal optique prélevé e et que la puissance de l'onde de compensation E* soit ajustée en conséquence. Cette dernière condition peut être satisfaite par un réglage de la puissance de l'onde continue CW, en agissant sur le courant I injecté dans le laser LD.

Concernant la linéarité, il faut tenir compte des caractéristiques du modulateur Mach-Zehnder 3. La transmission T du modulateur en fonction de la tension V appliquée varie selon la courbe représentée schématiquement à la figure 7. La tension de commande V variant entre deux valeurs V1 et V2 centrées autour de la tension de polarisation Vp, pour obtenir une réponse linéaire il suffit de choisir Vp, V1 et V2 de façon à rester dans une région sensiblement linéaire de la courbe.

Le modulateur à structure interférométrique peut être remplacé par un modulateur à électroabsorption, comme illustré à la figure 9. Cette variante présente l'avantage d'une réponse linéaire sur une plage d'amplitude de modulation plus étendue.

La source laser LD et le modulateur 3, quel que soit son type, peuvent bien entendu être réalisés de façon intégrée.

La figure 8 représente un premier cas de réalisation toute optique des moyens de modulation 1. Ils sont en fait constitués d'un convertisseur de longueur d'onde comportant un second amplificateur optique semi-conducteur 5 qui reçoit l'onde porteuse optique auxiliaire CW et, par l'intermédiaire d'un circulateur 6, la partie e du signal optique d'entrée E0. L'amplificateur 5 fonctionne en régime de saturation et son gain est modulé en fonction de la modulation de la puissance de e. En traversant l'amplificateur 5, l'onde auxiliaire CW est amplifiée avec ce gain modulé et on obtient en sortie une onde e* dont la puissance est modulée en inverse par rapport à la puissance de e. L'onde e* est reçu par le circulateur 6 qui fournit alors l'onde de compensation E*.

L'amplificateur 5 sera choisi pour posséder une fréquence de coupure suffisamment élevée pour réagir aux fluctuations rapides d'amplitude du signal optique d'entrée E0 qui seraient insuffisamment filtrées par l'amplificateur OA.

Comme précédemment, il est souhaitable que les moyens de modulation 1 possèdent une réponse antilinéaire et que la puissance de l'onde de compensation E* soit bien ajustée. Pour cela, il faut tenir compte ici des caractéristiques de l'amplificateur 5, c'est-à-dire de sa courbe de gain. Cette courbe est analogue à celle représentée sur la figure 2.

Pour que la modulation de e entraîne une modulation en inverse du gain, on place le point de fonctionnement de l'amplificateur 5 dans la partie de la courbe de gain qui a une pente négative. Cette pente est sensiblement constante avec des échelles en décibels, mais avec des échelles linéaires les variations du gain ne sont pas rigoureusement proportionnelles à celles de la puissance optique d'entrée. La réponse des moyens de modulation 1 ne sera donc pas parfaitement linéaire.

Concernant l'ajustement de la puissance de l'onde de compensation E*, il peut être facilement réalisé par un réglage de la puissance de l'onde continue CW, en agissant sur le courant I injecté dans le laser LD.

Un problème peut se poser si la puissance moyenne du signal optique d'entrée E0, donc celle de e, varie au cours du temps alors que la puissance de l'onde continue CW reste constante. En effet, pour assurer à l'onde de compensation E* un taux d'extinction convenable, la puissance de l'onde continue CW est normalement faible par rapport à celle de e. Le point de fonctionnement de l'amplificateur 5 est alors pratiquement déterminé par la puissance moyenne de e. Si la puissance moyenne (exprimée en dBm) de E0 subit une augmentation ΔP(E), cela entraîne une même augmentation de celles de E et de e. Mais d'après la courbe de gain, pour un fonctionnement en régime de saturation, une augmentation ΔP(E) (en dBm) de la puissance moyenne de e entraîne une diminution de gain (en décibels) de sensiblement la même valeur. La puissance moyenne (en dBm) de e* et donc celle de E* subit par conséquent une diminution de cette même valeur.

Or, pour que la combinaison S de E et E* conserve une faible modulation, il faudrait au contraire que la puissance moyenne (en dBm) de E* augmente aussi de ΔP(E). Pour satisfaire à cette condition, une solution consiste à augmenter de 2ΔP(E) la puissance (en dBm) de l'onde continue CW.

Par conséquent, si on veut augmenter la dynamique en puissance du dispositif, c'est-à-dire qu'il reste efficace malgré d'éventuelles variations de puissance moyenne du signal d'entrée E0, il convient de prévoir des moyens d'ajustement automatique de la puissance moyenne de E*.

De tels moyens sont représentés schématiquement sur la figure 8. Ils comportent en cascade un photodétecteur 8, un filtre électronique passe-bas 9, un circuit électronique de commande 10 et une source de courant réglable 11. Le photodétecteur 8 est disposé pour recevoir une partie du signal d'entrée E0. La source de courant 11 délivre au laser LD un courant I variable en fonction d'un signal de commande fourni par le circuit 10.

Le filtre passe-bas 9 sert à extraire la puissance moyenne de E. Le circuit de commande 10 est prévu pour produire un signal de commande fonction de cette mesure et adapté aux caractéristiques de l'amplificateur 5 de façon à égaliser en permanence les puissance moyennes de E et de E*.

Optionnellement, on peut prévoir aussi un atténuateur ajustable 7 commandé également par le circuit 10 et disposé entre le circulateur 6 et le coupleur Ca. Cet élément permet une augmentation supplémentaire de la dynamique en puissance du dispositif.

Il convient de noter que cet ajustement automatique de la puissance moyenne de E* n'est utile en pratique que pour les puissances relativement fortes du signal d'entrée E0. En effet, pour les puissances suffisamment faibles pour placer l'amplificateur 5 en régime peu saturé, son gain est faiblement modulé mais est élevé. Il en résulte que la puissance de e* est également faiblement modulé et élevée, mais la modulation du signal d'entrée E0 aura peu d'influence sur celle du signal de combinaison S.

En variante, comme représenté à la figure 10, les moyens de modulation 1 peuvent être constitués d'un convertisseur de longueur d'onde à structure interférométrique, par exemple de type Mach-Zehnder. La structure interférométrique est munie de deux branches dont deux extrémités reçoivent une partie de l'onde auxiliaire CW. Le signal e est injecté dans une des branches qui comprend un matériau dont l'indice varie en fonction de la puissance optique reçue. Les autres extrémités des branches sont couplées pour fournir l'onde de compensation E*.

Comme précédemment, on peut prévoir des moyens d'ajustement automatique de la puissance moyenne de E*. Il est également possible de placer en cascade les deux types de convertisseurs de longueur d'onde.

Un autre mode de réalisation représenté à la figure 12 concerne le cas où le signal optique à amplifier E est produit à partir d'un signal d'entrée électrique E0 disponible au niveau de l'amplificateur OA. Cette situation se présente dans les terminaux émetteurs munis d'un amplificateur d'émission appelé habituellement "booster".

Comme représenté, le signal à amplifier E est fourni par un modulateur électrooptique 11 recevant une onde porteuse de signal λi et commandé par le signal électrique E0.

Les moyens de modulation 1 sont alors constitués d'un autre modulateur électrooptique 12 recevant l'onde auxiliaire CW et commandé par un signal électrique complémentaire E0* du signal électrique d'entrée E0.

## Revendications

1. Dispositif pour amplifier au moyen d'un amplificateur optique semi-conducteur (OA) un signal optique modulé en amplitude, appelé signal à amplifier (E), et porté par au moins une longueur d'onde de signal (λi), **caractérisé en ce qu'**il comporte :
- des moyens de compensation pour produire une onde optique de compensation (E*),
- des moyens de couplage (Ca) pour injecter dans ledit amplificateur (OA) ledit signal optique à amplifier (E) et ladite onde optique de compensation (E*),
et **en ce que** lesdits moyens de compensation comprennent des moyens de modulation (1) commandés directement en fonction de la modulation du signal à amplifier (E), pour produire ladite onde optique de compensation (E*) par modulation d'amplitude d'au moins une onde porteuse optique auxiliaire (CW), de sorte que la combinaison (S) dudit signal optique à amplifier (E) et de ladite onde optique de compensation (E*) présente une modulation d'amplitude supprimée ou au moins atténuée.

2. Dispositif selon la revendication 1, **caractérisé en ce que** ladite onde porteuse optique auxiliaire (CW) a une longueur d'onde de compensation (λc) distincte de ladite ou desdites longueur(s) d'onde de signal (λi).

3. Dispositif selon l'une des revendications 1 ou 2, **caractérisé en ce que** lesdits moyens de compensation comportent un dispositif à retard (2) fournissant ledit signal à amplifier (E) à partir d'un signal optique d'entrée (E0) et **en ce que** lesdits moyens de modulation (1) sont aptes à moduler l'amplitude de ladite onde porteuse optique auxiliaire (CW) en inverse par rapport à la modulation dudit signal d'entrée (E0).

4. Dispositif selon la revendication 3, **caractérisé en ce que** lesdits moyens de modulation (1) comportent un photodétecteur (PD) recevant une partie (e) dudit signal optique d'entrée (E0) et commandant un modulateur électrooptique (3), ladite onde optique de compensation (E*) résultant de la modulation de ladite onde auxiliaire (CW) au moyen dudit modulateur électrooptique (3).

5. Dispositif selon la revendication 3, **caractérisé en ce que** ledit modulateur électrooptique (3) est un modulateur à structure interférométrique.

6. Dispositif selon la revendication 3, **caractérisé en ce que** ledit modulateur électrooptique (3) est un modulateur à électroabsorption.

7. Dispositif selon l'une des revendications 5 ou 6, **caractérisé en ce que** ledit modulateur électrooptique (3) et ladite source laser (LD) sont constitués d'un laser à modulateur intégré.

8. Dispositif selon la revendication 3, **caractérisé en ce que** lesdits moyens de modulation (1) comportent un second amplificateur optique semi-conducteur (5) recevant ladite onde porteuse optique auxiliaire (CW) et une partie (e) dudit signal optique d'entrée (E0), ladite onde optique de compensation (E*) résultant de l'amplification de ladite onde auxiliaire (CW) au moyen dudit second amplificateur (5), dont le gain est modulé par ladite partie (e) du signal optique d'entrée (E0).

9. Dispositif selon la revendication 3, **caractérisé en ce que** lesdits moyens de modulation (1) comportent une structure interférométrique munie de deux branches ayant chacune des première et seconde extrémités, lesdites premières extrémités recevant respectivement une partie de ladite onde auxiliaire (CW), une desdites branches comprenant un matériau dont l'indice varie en fonction de la puissance optique reçue et recevant une partie (e) dudit signal optique d'entrée (E0), lesdites secondes extrémités étant couplées pour fournir ladite onde optique de compensation (E*).

10. Dispositif selon l'une des revendications 8 ou 9, **caractérisé en ce qu'**il comporte des moyens (7, 8, 9, 10, 11) d'ajustement automatique de la puissance moyenne de ladite onde optique de compensation (E*) en fonction de la puissance moyenne dudit signal optique d'entrée (E0).

11. Dispositif selon l'une des revendications 1 ou 2, **caractérisé en ce que** ledit signal optique à amplifier (E) étant produit à partir d'un signal électrique d'entrée (E0), lesdits moyens de modulation (1) sont constitués d'un modulateur électrooptique (12) recevant ladite onde auxiliaire (CW) et commandé par un signal électrique complémentaire (E0*) dudit signal électrique d'entrée (E0).

12. Dispositif selon l'une des revendications 1 à 11, **caractérisé en ce que** ledit amplificateur optique semi-conducteur (OA) possède une fréquence de coupure inférieure à celle desdits moyens de modulation (1).

## Claims

1. A device for using a semiconductor light amplifier (OA) to amplify an amplitude-modulated optical signal referred to as the signal to be amplified (E) and carried by at least one signal wavelength (λi), the device being **characterized in that** it comprises:
- compensation means for producing a compensation light wave (E*); and
- coupling means (Ca) for injecting said optical signal to be amplified (E) and said compensation light wave (E*) into said amplifier (OA);
and **in that** said compensation means comprise modulation means (1) that are controlled directly as a function of the modulation of the signal to be amplified (E) so as to produce said compensation light wave (E*) by amplitude modulating at least one auxiliary light carrier wave (CW) in such a manner that the combination (S) of said optical signal to be amplified (E) and of said compensation light wave (E*) has amplitude modulation that is suppressed or at least attenuated.

2. A device according to claim 1, **characterized in that** said auxiliary light carrier wave (CW) has a compensation wavelength (λc) that is different from said signal wavelength(s) (λi).

3. A device according to claim 1 or 2, **characterized in that** said compensation means include a delay device (2) supplying said signal to be amplified (E) from an input optical signal (E0), and **in that** said modulation means (1) are suitable for modulating the amplitude of said auxiliary light carrier wave (CW) inversely relative to the modulation of said input signal (E0).

4. A device according to claim 3, **characterized in that** said modulation means (1) comprise a photodetector (PD) receiving a fraction (e) of said input optical signal (E0) and controlling an electrooptical modulator (3), said compensation light wave (E*) being the result of modulating said auxiliary wave (CW) by means of said electrooptical modulator (3).

5. A device according to claim 3, **characterized in that** said electrooptical modulator (3) is a modulator of interferometer structure.

6. A device according to claim 3, **characterized in that** said electrooptical modulator (3) is an electroabsorption modulator.

7. A device according to claim 5 or 6, **characterized in that** said electrooptical modulator (3) and said laser source (LD) are constituted by a laser with an integrated modulator.

8. A device according to claim 3, **characterized in that** said modulation means (1) comprise a second semiconductor light amplifier (5) receiving said auxiliary light carrier wave (CW) and a fraction (e) of said input optical signal (E0), said compensation light wave (E*) being the result of amplifying said auxiliary wave (CW) by means of said second amplifier (5) whose gain is modulated by said fraction (e) of the input optical signal (E0).

9. A device according to claim 3, **characterized in that** said modulation means (1) comprise an interferometer structure provided with two branches, each having first and second ends, said first ends receiving respective fractions of said auxiliary wave (CW), one of said branches including a material whose index varies as a function of the light power received and receiving a fraction (e) of said input optical signal (E0), said second ends being coupled together to provide said compensation light wave (E*).

10. A device according to claim 8 or 9, **characterized in that** it includes means (7, 8, 9, 10, 11) for automatically adjusting the mean power of said compensation light wave (E*) as a function of the mean power of said input optical signal (E0).

11. A device according to claim 1 or 2, **characterized in that** said optical signal to be amplified (E) is produced from an input electrical signal (E0) and said modulation means (1) are constituted by an electrooptical modulator (12) receiving said auxiliary wave (CW) and controlled by an electrical signal (E0*) that is the complement of said input electrical signal (E0).

12. A device according to any one of claims 1 to 11, **characterized in that** said semiconductor light amplifier (OA) possesses a cutoff frequency which is lower than the cutoff frequency of said modulation means (1).

## Patentansprüche

1. Vorrichtung zum Verstärken eines amplitudenmodulierten Signals, zu verstärkendes Signal (E) genannt, mittels eines optischen Halbleiter-Verstärkers (OA), das durch mindestens eine Signalwellenlänge (λi) getragen ist, **dadurch gekennzeichnet, dass** sie Folgendes aufweist:
- Kompensationsmittel, um eine optische Kompensationswelle (E*) zu erzeugen,
- Kopplungsmittel (Ca), um in den Verstärker (OA) das zu verstärkende optische Signal (E) und die optische Kompensationswelle (E*) zu injizieren,
und dadurch, dass die Kompensationsmittel Modulationsmittel (1) umfassen, die direkt als Funktion der Modulation des zu verstärkenden Signals (E) gesteuert sind, um die optische Kompensationswelle (E*) durch Amplitudenmodulation von mindestens einer optischen Hilfs-Trägerwelle (CW) zu erzeugen, derart, dass die Kombination (S) des zu verstärkenden optischen Signals (E) und der optischen Kompensationswelle (E*) eine unterdrückte oder zumindest gedämpfte Amplitudenmodulation aufweist.

2. Vorrichtung nach Anspruch 1,
**dadurch gekennzeichnet, dass** die optische Hilfs-Trägerwelle (CW) eine Kompensationswellenlänge (λc) hat, die von der oder den Signalwellenlänge(n) (λi) verschieden ist.

3. Vorrichtung nach Anspruch 1 oder 2,
**dadurch gekennzeichnet, dass** die Kompensationsmittel eine Verzögerungsvorrichtung (2) aufweisen, die das Signal (E), das ausgehend von einem optischen Eingangssignal (E0) zu verstärken ist, bereitstellen, und dass die Modulationsmittel (1) in der Lage sind, die Amplitude der optischen Hilfs-Trägerwelle (CW) bezogen auf die Modulation des Eingangssignals (E0) zu gegenmodulieren.

4. Vorrichtung nach Anspruch 3,
**dadurch gekennzeichnet, dass** die Modulationsmittel (1) einen Photozellendetektor (PD) aufweisen, der einen Teil (e) des optischen Eingangssignals (E0) empfängt und einen elektrooptischen Modulator (3) steuert, wobei die optische Kompensationswelle (E*) aus der Modulation der Hilfswelle (CW) mittels des elektrooptischen Modulators (3) resultiert.

5. Vorrichtung nach Anspruch 3,
**dadurch gekennzeichnet, dass** der elektrooptische Modulator (3) ein Modulator mit interferometrischer Struktur ist.

6. Vorrichtung nach Anspruch 3,
**dadurch gekennzeichnet, dass** der elektrooptische Modulator (3) ein Elektroabsorptionsmodulator ist.

7. Vorrichtung nach Anspruch 5 oder 6,
**dadurch gekennzeichnet, dass** der elektrooptische Modulator (3) und die Laserquelle (LD) aus einem Laser mit integriertem Modulator gebildet sind.

8. Vorrichtung nach Anspruch 3,
**dadurch gekennzeichnet, dass** die Modulationsmittel (1) einen zweiten optischen Halbleiter-Verstärker (5) aufweisen, der die optische Hilfs-Trägerwelle (CW) und einen Teil (e) des optischen Eingangssignals (E0) empfängt, wobei die optische Kompensationswelle (E*) aus der Verstärkung der Hilfswelle (CW) mittels des zweiten Verstärkers (5) resultiert, dessen Gain durch den Teil (e) des optischen Eingangssignals (E0) moduliert ist.

9. Vorrichtung nach Anspruch 3,
**dadurch gekennzeichnet, dass** die Modulationsmittel (1) eine interferometrische Struktur aufweisen, die mit zwei Zweigen versehen ist, die jeweils ein erstes und ein zweites Ende aufweisen, wobei die ersten Enden jeweils einen Teil der Hilfswelle (CW) empfangen, wobei einer der Zweige ein Material aufweist, dessen Index als Funktion der empfangenen optischen Leistung variiert und einen Teil (e) des optischen Eingangssignals (E0) empfängt, wobei die zweiten Enden gekoppelt sind, um die optische Kompensationswelle (E*) bereitzustellen.

10. Vorrichtung nach Anspruch 8 oder 9,
**dadurch gekennzeichnet, dass** sie Mittel (7, 8, 9, 10, 11) zum automatischen Justieren der Durchschnittsleistung der optischen Kompensationswelle (E*) als Funktion der Durchschnittsleistung des optischen Eingangssignals (E0) aufweist.

11. Vorrichtung nach Anspruch 1 oder 2,
**dadurch gekennzeichnet, dass**, wobei das zu verstärkende optische Signal (E) ausgehend von einem elektrischen Eingangssignal (E0) erzeugt wird, die Modulationsmittel (1) aus einem elektrooptischen Modulator (12) gebildet sind, der die Hilfswelle (CW) empfängt und durch ein komplementäres elektrisches Signal (E0*) des elektrischen Eingangssignals (E0) gesteuert ist.

12. Vorrichtung nach einem der Ansprüche 1 bis 11,
**dadurch gekennzeichnet, dass** der optische Halbleiter-Verstärker (OA) eine Grenzfrequenz besitzt, die niedriger als diejenige der Modulationsmittel (1) ist.
